# EUROPEAN PATENT APPLICATION

(11) **EP 1 329 962 A1**
(43) Date of publication of application: **23.07.2003**
(21) Application number: 02090016.3
(22) Date of filing: 16.01.2002
(51) Int. Cl.: H01L 39/12, H01L 39/24

(54) **Process for producing carbon-base superconductor**

(71) Applicant: Karimi, Amir, 14050 Berlin (DE)
(72) Inventor: Karimi, Mohsen, Shiraz 71346 (IR)

(57) **Abstract**

Heating copper (as powder, sheet and tube...) strongly in sulfur vapor in the presence of active carbon, leads to produce a carbon-copper (I)-sulfide compound with superconductivity property at 77 K . The process could be carried out in a sealed tube or an inert reactor, at 650-700 C and 15-20 atmosphere pressure. The product could be in powder, layer, sheet or piece form.

## Description

This patent describes a method for producing a high temperature superconductor material. Superconductors are materials those have no electrical resistance in specific conditions of temperature, pressure, .... .

Following this property they could be used in the field of electricity, electronic, magnet and etc.. They are used in very adequate equipment. Some of their most important currently or future use of them are: Magnetic Resonance Imaging (MRI), Magnetic-Levitation for trains, Sub-atomic particles accelerator, electric generator, energy storage, transformer, superprocessor, etc.

There are many types of materials those have superconductivity property such as: some pure metals (Hg, Pb), mixture of some metal-oxides (such as copper oxide) which called ceramic superconductors, Brocarbides, Fullerides (Cs3C60), organic compounds, alloys such as: metal alloys (AuZn3), metalloids (NbN, CuS, TaS₂), etc.

The compounds which are superconductor above 30 K at 1 atmosphere pressure are called "**H**igh **T**emperature **S**uperconductor" (**HTS**). These materials are mostly ceramic compounds. Some of them have Tc above 77 K (boiling point of nitrogen), which are brittle and mostly can not be melted (decompose at high temperature) to be shaped.

There are some carbon-base superconductors. Fullerides are the most famous ones such as Cs3C60 with Tc below 40 K . But other recent work shows that Tc in these compounds can rise up even in fullerene-base compounds. C60 molecule is superconductor at 18 K . Bertram Batlogg at Lucent Technologies claimed that superconductivity has observed at 117 K in a buckyball crystal by obliging the crystal to conduct with holes instead of electrons and by adding other molecular species to space out the buckyballs a bit. Theoretical activities show that carbon-36 fullerenes systems may lose all electrical resistance at temperature far higher than any other carbon structure (by a team of theorist at the Department of Energy's Lawrence Berkeley National Laboratory).

Direct reaction of sulfur with most metals lead to obtain metal-sulfide product (such as: FeS, Cu2S). Other non-metals such as phosphorus react with metals directly at high temperature and pressure, too.

This patent has no claim about the process of direct producing metalloid, which has already known, so the information such as pressure
and temperature which is related to this process could not be claimed in this application. Pressure and temperature in this reaction is relating to the reaction of copper and sulfur. At 1 atmosphere pressure, sulfur boiling point is 444.6'C, at 10 atm. the b.p. is 644'C, at 50 atm. the b.p. is 833'C.

This patent application is consisting of a process for producing a High Temperature Superconductor, which produce by heating copper strongly in sulfur vapor in the presence of active carbon (charcoal). Reaction could be carried out at 650-700'C in a sealed tube or in a reactor with sulfur vapor injection.

Copper can be used in two main forms:
1) Powder
2) Sheet, tube and etc. to occur reaction on a surface

There are two ways to carry out the process:
1) Using a sealed tube. Putting solid sulfur along with copper and carbon-powder in a sealed tube and heating the tube to 650-700'C. In this case, the amount of sulfur should be adequate, else excess of sulfur cause to rise pressure of the tube, which might not be sustained and controlled. Especially if the tube is a copper-tube.
2) Inject sulfur vapor into a reactor, which copper and carbon in proper condition (it is mentioned in the following) are inside.

- If it desired to use copper powder, it should be completely mixed with active carbon powder. Then there would be two cases:
   a) Putting above mixture along with enough solid sulfur in a proper inert tube and heating the tube. The tube should sustain against the pressure of sulfur vapor (15-20 atm.) at the temperature that is necessary to start reaction between copper and sulfur.
   b) Putting above mixture in an inert reactor. The temperature of the reactor should be high enough to reacting sulfur with copper (650-700'C). Injecting sulfur vapor to the reactor.

   The product would be a carbon -copper (I)-sulfide powder.
- If it desired to use copper sheet or tube, there would be two ways to carry out the process:
   a) Carbon should be laid down or be drawn on copper sheet in a reactor. Heating the reactor to 650-700'C and injecting sulfur vapor to the reactor. The product would be a layer of carbon -copper (I)-sulfide on the sheet surface.
   b) Putting carbon powder and solid sulfur in a copper-sealed-tube. Heating the tube to 650-700'C. Or carbon should be laid down or be drawn on a copper sheet and putting it along with enough solid sulfur in an inert sealed tube. Heating the sealed tube to 650-700'C lead to produce a layer of carbon- copper (I)-sulfide on the sheet surface or on the internal surface of copper-tube. This method could be used to produce solid piece of the product, too. The pieces could be ground to powder.

Mixing powders of copper (I) sulfide with active carbon and heating them to melting sulfide and mixing with carbon, would not show the same result of superconductivity as we see in the mentioned process. So consider to HTS product, the result might be related to presence of active carbon in direct production of copper (I)-sulfide (regarding to the conditions of this reaction such as pressure of sulfur vapor and temperature) and shows that the process of direct reaction of sulfur and copper is a subordinate of the process that is claimed in this application.

Best mode for carrying out the invention depends on the kind of product which is need. If powder product is needed, it is better to use copper powder. If product in sheet form is needed, it is better to use copper sheet. Using copper in sheet or belt form is better than the other case to obtain product in piece form.

Using reactor with sulfur vapor injection leads to obtain product with less impurity of remaining copper. By heating the reactor above boiling point of the sulfur, consider to the atmosphere pressure in the reactor, sulfur vapor could be extracted from the reactor. If product in powder form was obtained, by washing the product with carbon disulfide as a sulfur solvent, remaining sulfur, if any, could be separated from the powder product. Carrying out the process in a sealed tube might be easier case in small scale.

There are some problems to use most of superconductors. Some of them are superconductors at very low temperatures (in liquid helium that is more expensive and difficult than liquid nitrogen to obtain). Some of them made from rare and expensive elements (such as Au) or difficult to purify (such Yttrium-oxide). Some of them are not very stable such as Cs3C60, which decomposes when treating with water or air. And some of them decompose before melting (most ceramic ones). These limitations of the mentioned HTS materials cause to limit their use by industries or producing in large scale.

Instead, the process that is claimed here could be used for producing HTS compound in large scale, which could be melted above 1200 C, cheaper, more stable against oxidization and high temperature than many other ones. And the process itself is easier and cheaper to be carried out.
- This is an easy and simple example to carry out this process:
   Reagents:
      0.3 gr active carbon (charcoal) powder, 0.8 gr yellow sulfur powder, and 5 cm of a copper-pipe (∼5mm diameter) and enough thickness (∼ 0.5 mm)
   Equipment:
      Copper pipe to use as sealed tube (is mentioned above), normal flame
      1) Mix carbon and sulfur powders (normally)
      2) Close one side of the copper-pipe
      3) Put the mixture of(1) inside the copper-pipe
      4) Close the other site of the copper-pipe to have a copper-sealed tube
      5) Put the tube on the flame

CAUTION: The pressure in the sealed tube would rise up. To prevent sulfur vapor out, keep both side of copper-pipe by external force, for example by two pliers. Thickness of copper-pipe will decrease that react with sulfur, so its thickness should be enough at the beginning. Less than a minute, the temperature in the tube rise up and the reaction between sulfur and copper start. It would be a fast reaction and after seconds the reaction finish.

A layer of a solid carbon-copper (I)-sulfide is produced on internal surface of the tube. The product is brittle with dark gray-black color. Cool a piece of it to 77 K by liquid nitrogen, put it on a permanent magnet and you would see perfect diamagnetism property.

This HTS product reacts with acid solution (rapidly in oxidizing acids) and leads to produce hydrogen sulfide gas, copper solution and carbon powder precipitate, which is insoluble in water and toluene.

## Claims

1. A process, comprising:
Heating copper (as powder, sheet and tube...) strongly in sulfur vapor in the presence of active carbon, leads to produce a carbon-copper (I) - sulfide compound with superconductivity property at 77 K.

2. The process of claim 1 could be carried out in a sealed tube (made of copper as a reagent itself or an inert one) or in an inert reactor with sulfur vapor injection.

3. To obtain product in layer or sheet form in the process of claim 1, use copper sheet with active carbon layer on it.

4. To obtain product in powder form in process of claim 1, use copper powder, which is mixed completely with active carbon powder. Or grind the product which is in sheet, piece or block form.
